# EUROPEAN PATENT APPLICATION

(11) **EP 4 760 477 A1**
(43) Date of publication of application: **17.06.2026**
(21) Application number: 25154009.2
(22) Date of filing: 27.01.2025
(51) Int. Cl.: G06F 3/14, F21S 4/00, G09F 9/33, G09G 3/20, H01L 25/075, H01L 25/16, H05B 45/10, H05B 45/54

(54) **LED LIGHT STRING, LED LIGHT BOARD, AND LED DISPLAY**

(30) Priority: 13.12.2024 CN 202423091104 U; 13.12.2024 CN 202423104688 U; 13.12.2024 CN 202423092228 U
(71) Applicant: Roe Visual Co Ltd, Shenzhen City, Guangdong 518000 (CN)
(72) Inventor: LI, Xiaochao, Shenzhen City (CN); MENG, Linke, Shenzhen City (CN)
(74) Representative: Renaudo, Adrien Hanouar

(57) **Abstract**

The embodiment of the present disclosure provides an LED light string, an LED light board, and an LED display. In the embodiments of the present disclosure, a first signal input port (DI) and a second signal output port (FDO) of the LED bead (100) are electrically connected directly to form a first breakpoint continuation line, to ensure that data signals can still be transmitted to the next LED bead even if the LED driver chip does not work. A second signal output port (FDO) and a second signal input port (FDI) of a first LED bead and a second LED bead with at least two LED beads therebetween are electrically connected to form a second breakpoint continuation line, so that data signals can still be transmitted to the second LED bead and subsequent LED beads, even if a plurality of consecutive LED beads fail to work. Furthermore, power is supplied in a serial power supply way, to reduce power consumption; furthermore, power is supplied in a hybrid serial-parallel power supply way, to address the issue of power outages in subsequent LED beads caused by malfunction of some LED bead and improve the reliability of the LED display.

## Description

### TECHNICAL FIELD

The present disclosure relates to the field of display, and particularly to an LED light string, an LED light board, and an LED display.

### BACKGROUND

With a rapid development of technology, LED (Light Emitting Diode) technology, has been widely used in lighting, display fields and the like, due to its characteristics, such as high-power efficiency, long lifespan, and eco-friendly. Particularly, in the display field, LED display has become a preferred choice for indoor and outdoor advertising, stage backgrounds, information displaying, and other applications due to their excellent display performance and flexibility.

In the field of LED display, LED strip display is a common type of LED display and normally includes a controller and a plurality of LED light strings. Each LED light string includes a plurality of LED beads. The controller is configured to control the LED beads in the plurality of light strings for display by providing data signals to each LED light string. The data signal is transmitted sequentially from the first LED bead in the LED light string to the next LED bead in sequence, so that each LED bead performs display according to corresponding data.

There are following disadvantages in such LED strip display: if some LED beads in the same light string do not work, the subsequent LED beads may fail in receiving data signals properly.

### SUMMARY

Various aspects of the present disclosure provide an LED light string, an LED light board, and an LED display, so as to establish a breakpoint continuation line within the LED light string, to address the issue that subsequent LED beads fail to receive data signals due to a malfunction in preceding LED beads, so that the reliability of the LED display may be improved.

Embodiments of the present disclosure provide an LED light string including: a plurality of LED beads connected in series; each LED bead is provided with a first signal input port, a first signal output port, a second signal input port, and a second signal output port, and the LED bead is provided with an LED driver chip and an LED emitting unit encapsulated therein. The first signal input port, the second signal input port, the first signal output port, and the second signal output port of each LED bead are electrically connected to a first signal input pin, a second signal input pin, a first signal output pin, and a second signal output pin of an LED driver chip encapsulated in the LED bead, respectively, so as to transmit data signals to the LED emitting unit via any signal input pin of the LED driver chip. The first signal output port and the second signal output port of adjacent LED beads are electrically connected to the first signal input port and the second signal input port, respectively, to form a serial signal line. The first signal input port and the second signal output port of each LED bead are electrically connected directly by bypassing the LED driver chip inside the LED bead to form a first breakpoint continuation line.

Embodiments of the present disclosure provide an LED light board including: a plurality of LED light strings; each LED light string includes a plurality of LED beads, and each LED bead is provided with a first signal input port, a first signal output port, a second signal input port, and a second signal output port. The LED bead is provided with an LED driver chip and an LED emitting unit encapsulated therein. The first signal input port, the second signal input port, the first signal output port, and the second signal output port of each LED bead are electrically connected to a first signal input pin, a second signal input pin, a first signal output pin, and a second signal output pin of an LED driver chip encapsulated in the LED bead, respectively, so as to transmit data signals to the LED emitting unit via any signal input pin of the LED driver chip. The first signal output port and the second signal output port of adjacent LED beads are electrically connected to the first signal input port and the second signal input port, respectively, to form a serial signal line. The first signal input port and the second signal output port of each LED bead are electrically connected directly by bypassing the LED driver chip of the LED bead to form a first breakpoint continuation line.

Embodiments of the present disclosure provide an LED display including: a controller and at least two LED light boards; the at least two LED light boards are sequentially connected together to form the LED display; the controller is provided at top and/or bottom of the LED display; each LED light board includes: a plurality of LED light strings; each LED light string includes a plurality of LED beads, and each LED bead is provided with a first signal input port, a first signal output port, a second signal input port, and a second signal output port. The LED bead is provided with an LED driver chip and an LED emitting unit encapsulated therein. The first signal input port, the second signal input port, the first signal output port, and the second signal output port of each LED bead are electrically connected to a first signal input pin, a second signal input pin, a first signal output pin, and a second signal output pin of an LED driver chip encapsulated in the LED bead, respectively, so as to transmit data signals to the LED emitting unit via any signal input pin of the LED driver chip. The first signal output port and the second signal output port of adjacent LED beads are electrically connected to the first signal input port and the second signal input port, respectively, to form a serial signal line. The first signal input port and the second signal output port of each LED bead are electrically connected directly by bypassing the internal LED driver chip of the LED bead to form a first breakpoint continuation line. The signal transmission direction in at least two LED light boards is the same, or the signal transmission direction of at least some adjacent LED light boards of the at least two LED light boards is opposite.

Embodiments of the present disclosure provide an LED light board including: a plurality of LED light strings; each LED light string includes a plurality of LED beads, and each LED bead is provided with a power input port and a power output port. The LED bead is provided with an LED driver chip and an LED emitting unit encapsulated therein. The power input port and the power output port of each LED bead are electrically connected to a power input pin and a power output pin of an LED driver chip encapsulated in the LED bead, respectively, so as to supply power signals to the LED emitting unit via the LED driver chip. The power output port and the power input port of adjacent LED beads in the same LED light string are electrically connected, to form a serial power supply line. The serial power supply lines of adjacent LED light strings are connected in parallel, to form a parallel power supply line.

Embodiments of the present disclosure provide an LED display including: a controller and at least two LED light boards. Each LED light board includes: a plurality of LED light strings; each LED light string includes: a plurality of LED beads, and each LED bead is provided with a power input port and a power output port. The LED bead is provided with an LED driver chip and an LED emitting unit encapsulated therein. The controller is electrically connected to a power input port of the first LED bead and a power output port of the last LED bead, so as to supply power signal to the LED bead. The power input port and the power output port of each LED bead are electrically connected to a power input pin and a power output pin of an LED driver chip encapsulated in the LED bead, respectively, so as to supply power signals to the LED emitting unit via the LED driver chip. The power output port and the power input port of adj acent LED beads in a same LED light string are electrically connected, to form a serial power supply line. The serial power supply lines of adjacent LED light strings are connected in parallel, to form a parallel power supply line.

In the embodiments of the present disclosure, the first signal input port and the second signal output port of the LED beads are electrically connected directly to form a first breakpoint continuation line, so that data signals can still be transmitted to the next LED bead even if the LED driver chip does not work, to address the issue that data signals cannot be transmitted to subsequent LED beads due to a malfunction in some LED bead.

Furthermore, alternatively, the second signal output port and the second signal input port between a first LED bead and a second LED bead with at least two LED beads therebetween are electrically connected to form a second breakpoint continuation line, so that data signals can still be transmitted to the second LED bead and subsequent LED beads, even if a plurality of consecutive LED beads do not work, and the issue that data signals cannot be transmitted to subsequent LED beads due to a malfunction in a plurality of consecutive LED beads may be addressed.

Furthermore, alternatively, power may be supplied to the LED light string in a serial power supply way, to reduce power consumption.

Furthermore, alternatively, power may be supplied to LED light boards and LED display in a hybrid serial-parallel power supply way, to reduce power consumption and address the issue of power outages in subsequent LED beads caused by malfunction of some LED bead in a serial power supply way, and the number of LED beads in power outage may be reduced, to reduce a risk that the whole LED display does not work, and improve the reliability of the LED display.

### BRIEF DESCRIPTION OF THE DRAWINGS

The drawings described herein are provided to facilitate a better understanding of the present disclosure, and form a part of the present disclosure. The illustrative embodiments and descriptions in the present disclosure are used to explain the present disclosure and do not make improper limitations on the present disclosure. In the drawings:
FIG. 1a is schematic structural view of an LED bead provided in an exemplary embodiment of the present disclosure;
FIG. 1b is a schematic structural view of another LED bead provided in an exemplary embodiment of the present disclosure;
FIG. 2a is schematic structural view of an LED light string provided in an exemplary embodiment of the present disclosure;
FIG. 2b is schematic structural view of another LED light string provided in an exemplary embodiment of the present disclosure;
FIG. 2c is schematic structural view of yet another LED light string provided in an exemplary embodiment of the present disclosure;
FIG. 2d is a schematic structural view of still another LED light string provided in an exemplary embodiment of the present disclosure;
FIG. 3a is a schematic structural view of an LED light board with power supplied in series provided in an exemplary embodiment of the present disclosure;
FIG. 3b is a schematic structural view of an LED light board with power supplied in series-parallel hybrid provided in an exemplary embodiment of the present disclosure;
FIG. 4a is a schematic structural view of an LED display provided in an exemplary embodiment of the present disclosure;
FIG. 4b is a schematic structural view of another LED display provided in an exemplary embodiment of the present disclosure;
FIG. 4c is schematic structural view of yet another LED display provided in an exemplary embodiment of the present disclosure;
FIG. 4d is schematic structural view of still another LED display provided in an exemplary embodiment of the present disclosure.

### DETAILED DESCRIPTION

To better clarify the objectives, technical solutions, and advantages of the present disclosure, the technical solutions of the present disclosure will be described in detail below in conjunction with embodiments and corresponding drawings. It is obvious that the described embodiments are only part of the embodiments of the present disclosure and not all of them. Based on the embodiments in the present disclosure, all other embodiments obtainable by those skilled in the art without creative efforts fall within the scope of the present disclosure.

To address the technical issue that subsequent LED beads fail to receive data signals due to a malfunction in some of preceding LED beads in a same LED light string, in embodiments of the present disclosure, the first signal input port and the second signal output port of the LED bead are electrically connected directly to form a first breakpoint continuation line, so that data signals can still be transmitted to the next LED bead even if the LED driver chip does not work, to address the issue that data signals cannot be transmitted to subsequent LED beads due to a malfunction in some LED bead.

Furthermore, alternatively, in embodiments of the present disclosure, the second signal output port and the second signal input port between a first LED bead and a second LED bead with at least two LED beads therebetween are electrically connected to form a second breakpoint continuation line, so that data signals can still be transmitted to the second LED bead and subsequent LED beads, even if a plurality of consecutive LED beads do not work, and the issue that data signals cannot be transmitted to subsequent LED beads due to a malfunction in a plurality of consecutive LED beads may be addressed.

Furthermore, alternatively, power may be supplied to the LED light string in a serial power supply way, to reduce power consumption.

Furthermore, alternatively, power may be supplied to LED light boards and LED display in a hybrid serial-parallel power supply way, to reduce power consumption and address the issue of power outages in subsequent LED beads caused by malfunction of some LED bead in a serial power supply way, and the number of LED beads in power outage may be reduced. At least two LED light boards are sequentially connected together to form the LED display. Serial power supply lines in adjacent rows or columns are connected in parallel for the LED beads in the LED light board, to form a parallel power supply line, and a power switch circuit inside each LED bead may choose power supply line intelligently, to reduce a risk that the whole LED display does not work due to malfunction of some LED beads, and improve the reliability of the LED display.

The technical solutions provided in the embodiments of the present disclosure are described in detail below with reference to the drawings.

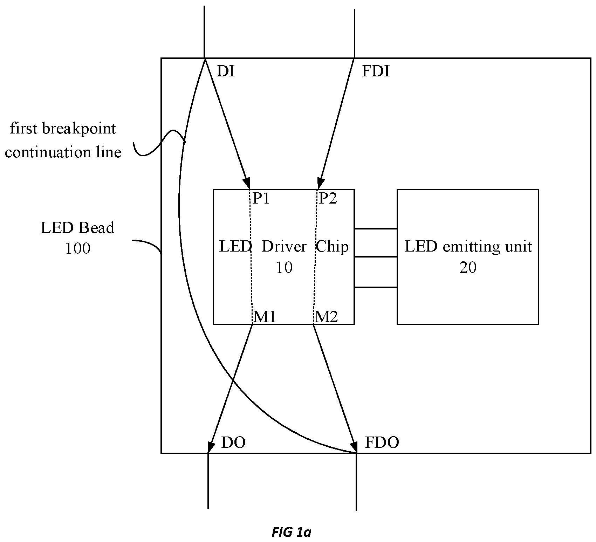

FIG. 1a illustrates a schematic structural view of an LED bead provided in an exemplary embodiment of the present disclosure. As shown in FIG. 1a, the present disclosure provides a novel structure for LED bead, i.e., LED bead 100. The LED bead 100 is provided with an LED driver chip 10 and an LED emitting unit 20 encapsulated therein.

The LED emitting unit 20 is an essential light-emitting component, consisting of one or more LED chips and their related auxiliary components. The LED emitting unit 20 is a core part for outputting light and may be a diode made of semiconductor materials and emit light when current flows therethrough. The semiconductor materials that may be used for the LED emitting unit 20 may include, but not be limited to, gallium arsenide (GaAs), gallium nitride (GaN), and aluminum gallium indium phosphide (AlGaInP), and so on.

The LED driver chip 10 is an integrated circuit for controlling and driving the LED emitting unit and is mainly used to ensure that the LED emitting unit 20 operates under safe and efficient conditions and to provide various additional functions to meet needs of various application scenarios. The additional functions may include, but not be limited to, display control for the LED emitting unit 20, power supply control for the LED emitting unit 20, and so on. Display control for the LED emitting unit 20 may include, but not be limited to, providing data signals to the LED emitting unit 20, dimming control of the LED emitting unit 20, and so on. Power supply control may include, but not be limited to, supply power current to the LED emitting unit 20, overvoltage protection (to prevent damage to the LED emitting unit due to excessive input voltage), overcurrent protection (to prevent overheating or damage to the LED emitting unit due to excessive current), and short-circuit protection (to automatically cut off the power supply when a short circuit occurs, for safety of the LED emitting unit).

Each of the LED driver chip 10 and the LED emitting unit 20 has a plurality of pins. The LED driver chip 10 may control and drive the LED emitting unit 20 to emit light based on interconnections of these pins. These pins are electrically connected under circuit design, so that the LED driver chip 10 may transmit data signals to the LED emitting unit 20. These data signals may control operations of the LED emitting units 20. Various operations of the LED emitting unit 20 may be controlled according to different input signals. The operations may include brightness adjustment, color correction, temperature compensation, and so on. The signal driving forms of these data signals may vary as long as they meet requirements for LED display, and there is no limitation on the forms in embodiments of the present disclosure. For example, signal driving may be simple clock driving for synchronizing data signals, data driving for transmitting image or text information, or control driving for adjusting the on/off state and brightness of the LEDs. In this way, the LED emitting unit 20 may accurately reproduce various images and videos, to provide a rich and colorful visual experience. In embodiments of the present disclosure, there is no limitation on the internal structure and pins of the LED driver chip 10 and the LED emitting unit 20. Exemplary explanation would be made on the pins of the LED driver chip 10 and the LED emitting unit 20 in a functional perspective.

The pins of the LED driver chip 10 may include, but not be limited to: 1. power input pin V1 for receiving external power signals; 2. ground pin as ground line for circuit, for reference voltage to be connected to external common ground line; 3. dimming control pin for receiving dimming signals, such as PWM signals or analog voltage, to adjust brightness of the LEDs; 4. enable pin for controlling the on/off state of the LED driver chip 10; 5. power output pin V2 for supplying driving current to the LED emitting unit 20; 6. communication interface pin for digital communication between the LED emitting unit 20 and external devices. In embodiments of the present disclosure, the communication interface pins of the LED driver chip 10 may include at least a first signal input pin P1, a first signal output pin M1, a second signal input pin P2, and a second signal output pin M2, as well as signal control pins as an example.

The pins of the LED emitting unit 20 may include, but not be limited to: 1. positive pin as a positive electrode for LED and for receiving incoming current, positive pin may be connected to the power output pin V2 of the LED driver chip 10; 2. negative pin as a negative electrode for LED and for outputting current, negative pin may be connected to the ground or directly to the power output pin V2 of the LED driver chip 10; 3. communication pin to be connected to the communication interface pin of the LED driver chip 10, such as signal control pin, so as to receive data signals for display.

In embodiments of the present disclosure, in order to facilitate the provision of data signals from external sources (e.g., a controller of an LED display) to the LED driver chip 10, the data signals refer to display data required for controlling the LED beads to display. As shown in FIG. 1a, the LED bead 100 is provided with a first signal input port DI, a first signal output port DO, a second signal input port FDI, and a second signal output port FDO outwardly. The first signal input port DI and the first signal output port DO are electrically connected to the first signal input pin P1 and the first signal output pin M1 of the LED driver chip 10, to form a transmission line for data signal. The second signal input port FDI and the second signal output port FDO are electrically connected to the second signal input pin P2 and the second signal output pin M2 of the LED driver chip 10, to form another transmission line for data signal. The LED driver chip 10 may transmit data signals to the LED emitting unit 20 through these two transmission lines so as to control the display on the LED emitting unit 20.

Furthermore, the first signal output port DO and the second output port FDO of the LED bead 100 are electrically connected to the first signal input port DI and the second signal input port FDI of the next LED bead 100 in the LED light string, to which the LED bead 100 belongs. That is to say, corresponding signal input ports and signal output ports between adjacent LED beads 100 may be electrically connected to form a serial signal line, and the serial signal line may be configured to ensure that data signals may be continuously transmitted to subsequent LED beads 100.

Regarding each LED bead 100, data signals may be input into the first signal input pin P1 of the LED driver chip 10 via the first signal input port DI, pass through the first signal output pin M1 of the LED driver chip 10, and be transmitted into the first signal output port DO, and then input into the next LED bead 100 through the first signal input port DI of the next LED bead 100 for serial transmission. Alternatively, data signals may be input into the second signal input pin P2 of the LED driver chip 10 via the second signal input port FDI of the LED bead 100, pass through the second signal output pin M2 of the LED driver chip 10, and transmitted into the second signal output port FDO, and then input into the next LED bead 100 via the second signal input port FDI of the next LED bead 100 for serial transmission. As such, both transmission lines pass through the LED driver chip 10. If the LED driver chip 10 malfunctions or the LED bead 100 does not work, data signals cannot be transmitted to subsequent beads continuously.

To improve tolerance on fault in data signal transmission between LED beads 100, in the embodiments of the present disclosure, a first breakpoint continuation line is provided between the first signal input port DI and the second signal output port FDO of the LED bead 100. That is to say, the first signal input port DI and the second signal output port FDO are electrically connected directly by bypassing (or skipping) the LED driver chip 10. For example, the first signal input port DI and the second signal output port FDO may be electrically connected directly via a wire. Alternatively, a trace (or wiring) may be added between the first signal input port DI and the second signal output port FDO by bypassing the LED driver chip on the PCB board where the LED bead 100 is located, and the first signal input port DI and the second signal output port FDO may be electrically connected by this trace, so as to form the first breakpoint continuation line between the first signal input port DI and the second signal output port FDO.

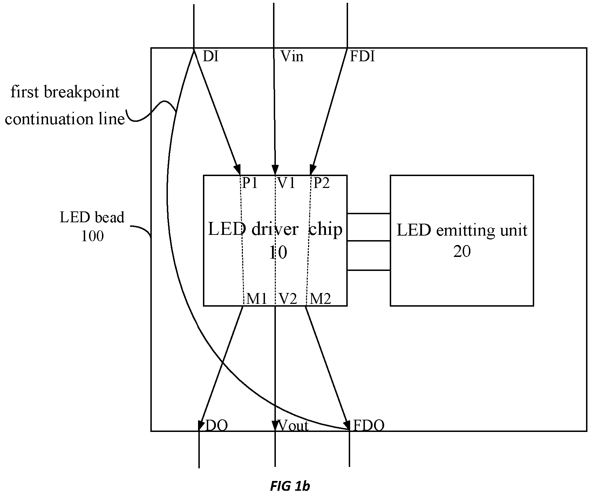

With the first breakpoint continuation line added, if the LED driver chip 10 in the LED bead 100 fails (or the LED bead 100 itself malfunctions), data signals cannot be transmitted to subsequent LED beads 100 continuously through the two transmission lines: first signal input port DI of the LED bead 100 → the first signal input pin P1 of the LED driver chip → the first signal output pin M1 → the first signal output port DO of the LED bead 100, and the second signal input port FDI of the LED bead 100 → the second signal input pin P2 of the LED driver chip → the second signal output pin M2 → the second signal output port FDO of the LED bead 100. However, the data signals can still be transmitted to subsequent LED beads 100 via the first breakpoint continuation line of the first signal input port DI → the second signal output port FDO of the LED bead 100 with the LED driver chip bypassed, to ensure a stable operation of the entire LED light string and reduce a risk that the entire LED light string does not work due to malfunction of a single LED bead 100 or driver chip. FIG. 1b illustrates a schematic structural view of another LED bead 100 provided in exemplary embodiments of the present disclosure. As shown in FIG. 1b, the LED bead 100 may be further provided with a power input port Vin and a power output port Vout. The power input port Vin and the power output port Vout of the LED bead 100 may be electrically connected to the power input pin V1 and the power output pin V2 of the LED driver chip 10, respectively, to supply power signals to the LED emitting unit 20 through the LED driver chip 10. Additionally, the power output port Vout of the current LED bead 100 may be electrically connected to the power input port Vin of the next LED bead 100, so as to form a serial power supply line between adjacent LED beads 100. This serial power supply line allows a plurality of LED beads 100 connected in series to share the same power source. The voltage supplied by the power source may be allocated among the plurality of LED beads 100, to optimize power resource utilization and reduce power consumption. Alternatively, when loads of a plurality of LED beads 100 are identical, the voltage signal supplied by the power source may be evenly allocated among the plurality of LED beads 100. For example, if the power supply voltage is 20 volts and each LED bead 100 requires 5 volts, five LED beads 100 may be connected in series.

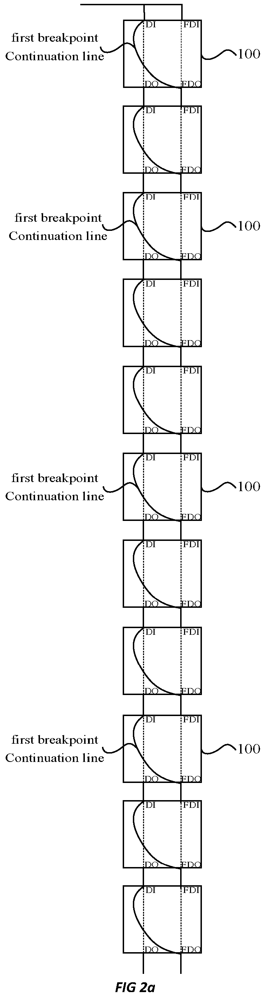

Besides the LED bead 100 as shown in FIG. 1a or FIG. 1b, the embodiments of the present disclosure further provide an LED light string. Fig. 2a illustrates a schematic structural view of an LED light string provided in exemplary embodiments of the present disclosure. As shown in FIG. 2a, the LED light string may include a plurality of LED beads 100 connected in series. The serial connection may include both the serial transmission of data signals and the serial transmission of power signals. There is no limitation on the number of LED beads 100 in the LED light string and the number may be, for example, 10, 30, 50, 100, etc., depending on the application scenario or the size of the display. In FIG. 2a, the LED light string is illustrated with 11 LED beads 100 as an example, but the number of the LED beads 100 is not limited to this. The structure of each LED bead 100 may be as shown in FIG. 1a or FIG. 1b. Specifically, each LED bead 100 may be provided with a first signal input port, a first signal output port, a second signal input port, and a second signal output port. Each LED bead 100 may be provided with an LED driver chip and an LED emitting unit encapsulated therein. In the LED light string, the first signal input port and second signal input port of the first LED bead 100 are configured to receive data signals from the controller. When the controller outputs data signals, the first signal input port and/or second signal input port of the first LED bead 100 receive these data signals and then transmit them to the next LED bead 100 through its first signal output port and/or second signal output port. In this way of serial connection, data signals can be ensured to be sequentially transmitted from one LED bead 100 to the next till the last LED bead in the LED light string.

In the embodiments of the present disclosure, each LED bead 100 in the LED light string has two signal input ports (DI and FDI) and two signal output ports (DO and FDO). Each LED bead 100 may be provided with an LED driver chip and an LED emitting unit encapsulated therein. The first signal input port (DI) and the second signal output port (FDO) of each LED bead 100 may be electrically connected directly to form a path referred as the "first breakpoint continuation line". When the LED driver chip works normally, data signals is input into the LED bead 100 through DI or FDI, and then transmitted to the next LED bead via DO or FDO after being processed by the LED driver chip. However, if the LED driver chip malfunctions, data signals cannot be output through DO or FDO. In this case, due to the direct electrical connection between DI and FDO, data signals may be transmitted directly from DI to the next LED bead 100 through FDO by bypassing the faulty LED driver chip. In this way, even if the LED driver chip in a particular LED bead 100 does not work, data signals may still be transmitted to the next LED bead 100, to keep he continuity of data transmission throughout the LED light string.

In addition, the power input port Vin of each LED bead 100 may receive power signals provided by the controller and transmit them to the power input port Vin of the next LED bead 100 through its power output port Vout, so that a serial connection for power signals may be achieved. In this way, power supply from the power source to each LED bead 100 may be continuous and stable.

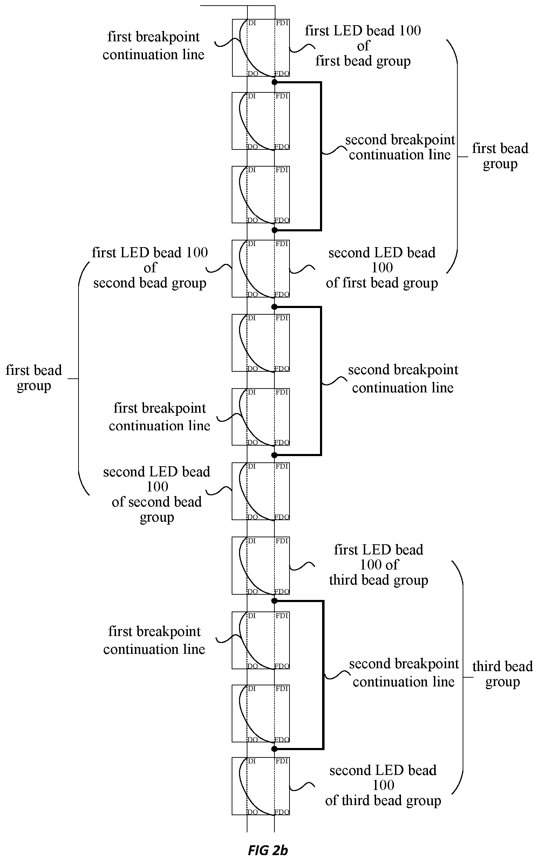

FIG. 2b illustrates a schematic structural view of another LED light string provided in exemplary embodiments of the present disclosure. Besides the LED light string shown in FIG. 2a, in FIG. 2b, the second signal output port of the first LED bead 100 and the second signal input port of the second LED bead 100 may be electrically connected, to form a second breakpoint continuation line. In this way, even when two or more consecutive LED beads 100 between the first LED bead 100 and the second LED bead 100 do not work, data signals can still be transmitted to the second LED bead 100 and subsequent LED beads 100. The first LED bead 100 may be any LED bead 100 in the LED light string, and there may be at least two LED beads between the second LED bead 100 and the first LED bead 100.

For better clarification, the first LED bead 100 and the second LED bead 100 may be grouped to form one bead group, and there may be at least two LED beads between the second LED bead 100 and the first LED bead 100 in one bead group. For example, there may be 2 LED beads 100 between the second LED bead 100 and the first LED bead 100 in one bead group, and there may be 3, 4, or more LED beads 100 between the second LED bead 100 and the first LED bead 100 in one bead group. In FIG. 2b, there are two LED beads 100 illustrated as an example between the second LED bead 100 and the first LED bead 100, but number of the LED beads between the second LED bead 100 and the first LED bead 100 in one bead group is not limited to this.

There may be one or more bead groups in one LED light string. When there are a plurality of bead groups in one LED light string, different bead groups may have different first LED beads 100 and second LED beads 100. When two or more consecutive LED beads 100 between the first LED bead 100 and the second LED bead 100 fail to work, these failed LED beads 100 may not be able to transmit data signals to subsequent LED beads 100 through the serial transmission line therebetween. However, data signals can still be transmitted to the next LED bead 100 via the first breakpoint continuation line. Furthermore, if the next LED bead 100 also fails to work, it will no longer be possible to continue transmitting data signals to subsequent LED beads 100 through the first breakpoint continuation line within the LED bead 100. However, due to the presence of the second breakpoint continuation line, data signals may be directly transmitted from the second signal output port of the first LED bead 100 to the second signal input port of the second LED bead 100 through the second breakpoint continuation line, so that it can be ensured that data signals are transmitted to the second LED bead 100 and its subsequent beads continuously. The second breakpoint continuation line may directly bypass the failed LED beads 100 in the middle, to ensure that data signals may be transmitted to the second LED bead 100 and its subsequent LED beads 100 continuously. In this way, the whole LED light string would not fail to work even when part of the LED beads 100 in the LED light string fails to work, so that the performance of the LED light string may be improved.

For example, in the first bead group of LED beads 100 shown in FIG. 2b, there are two LED beads 100 between the first LED bead 100 and the second LED bead 100. The second signal output port of the first LED bead 100 and the second signal input port of the second LED bead 100 are electrically connected to form a second breakpoint continuation line. When the first LED bead 100 is followed by a failed LED bead 100, the first breakpoint continuation line may bypass the failed LED bead 100 and transmit the data signal to the subsequent LED bead 100. However, if two consecutive LED beads 100 following the first LED bead 100 fail to work, data signals cannot be transmitted via the first breakpoint continuation line. At this time, the second breakpoint continuation line may bypass the two failed beads and the data signal may be directly transmitted from the first LED bead 100 to the second LED bead 100 via the second breakpoint continuation line.

In this embodiment, different bead groups in the LED light string may have different first LED beads 100 and second LED beads 100. As shown in FIG. 2b, the first LED beads 100 and the second LED beads 100 in the first bead group, the second bead group, and the third bead group are all different.

In embodiments of the present disclosure, there is no limitation on the positional relationship between the first LED bead 100 in one bead group and the second LED bead 100 in another bead group. In an alternative embodiment, in two adjacent bead groups of an LED light string, the first LED bead 100 in latter bead group may be an LED bead 100 located before the second LED bead 100 in former bead group but is different from the first LED bead 100 in the former bead group. In this way, adjacent bead groups may be intervened with each other, so that the impact of failed LED beads 100 may be further reduced. In another alternative embodiment, in two adjacent bead groups of an LED light string, the first LED bead 100 in the latter bead group may be the second LED bead 100 in the former bead group or an LED bead 100 located thereafter, so that the adjacent bean groups may be in sequence without intervening with each other.

Furthermore, alternatively, when there is only one LED bead 100 between two adjacent second breakpoint continuation lines in one LED light string, this only one LED bead may be the second LED bead 100 in the preceding bead group and the first LED bead 100 in the subsequent bead group. When there are at least two LED beads 100 between two adjacent second breakpoint continuation lines in an LED light string, the first LED bead 100 in the latter bead group may be an LED bead 100 located after the second LED bead 100 in the former bead group. As shown in FIG. 2b, there is only one LED bead 100 between the second breakpoint continuation line in the first bead group and the second breakpoint continuation line in the second bead group. This only one LED bead 100 may be the second LED bead 100 in the first bead group and the first LED bead 100 in the second bead group at the same time. When there are two LED beads 100 between the second breakpoint continuation line in the second bead group and the second breakpoint continuation line in the third bead group, the first LED bead 100 in the third bead group may be the LED bead 100 immediately after the second LED bead 100 in the second bead group.

In this embodiment, the number of LED beads 100 between the first LED bead 100 and the second LED bead 100 in different LED bead groups may be the same or different. The number of LED beads 100 between the first LED bead 100 and the second LED bead 100 in an LED bead group may be adjusted based on various application scenarios, which includes voltage requirement of each LED bead 100 or the failure probability of LED beads 100. There is no limitation on this number in embodiments of the present disclosure. For example, if it is required that the voltage of LED beads 100 in the LED light string should be the same in some application scenario, the number of LED beads 100 between the first LED bead 100 and the second LED bead 100 in different LED bead groups of the LED light string may be the same. If it is required that the first LED bead group is a group of LED beads 100 with high voltage and the second LED bead group is a group of LED beads 100 with low voltage in some application scenario, there are two LED beads 100 between the first LED bead 100 and the second LED bead 100 in the first LED bead group, while there may be five LED beads 100 between the first LED bead 100 and the second LED bead 100 in the second LED bead group, so that the number of LED beads 100 between the first LED bead and the second LED bead in different LED bead groups of the LED light string may be different.

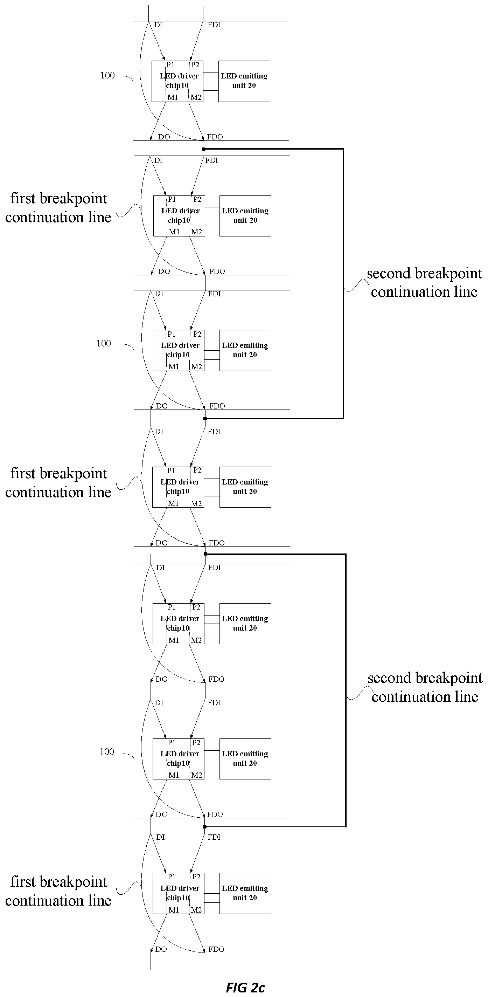

FIG. 2c illustrates a schematic structural view of another LED light string provided in exemplary embodiments of the present disclosure. The LED light strings shown in FIG. 2a and FIG. 2b are same as the LED light strings shown in FIG. 2c, except that the LED light string shown in FIG. 2c shows an internal partial structure of the LED beads 100. As shown in FIG. 2c, the LED light string may include a plurality of LED beads 100 connected in series. The serial connection relationship between the plurality of LED beads 100 and data signal transmission lines are the same as in the previous embodiments and detailed description may be omitted to avoid redundance. Similarly, the internal structure of each LED bead 100 is also the same as the structure of the LED bead 100 in the previous embodiments and detailed description may be omitted to avoid redundance.

Furthermore, alternatively, in the LED light string shown in FIG. 2c, the LED driver chip in the LED bead 100 may include: a monitoring circuit electrically connected to the first signal input pin and the second signal input pin of the LED driver chip; a parsing circuit electrically connected to the monitoring circuit; and a driving circuit electrically connected to the parsing circuit. The monitoring circuit is configured to monitor whether data signals are received on the first signal input pin and the second signal input pin and output the data signal and the pin identifier of any signal input pin receiving the data signal to the parsing circuit when a data signal is detected to be received on any signal input pin.

It should be noted that data signals may be received by both signal input pins. Alternatively, if data signals are received sequentially by the two signal input pins, the signal input pin that receives the data signal earlier is prioritized. The pin that receives the data signal earlier may be designated as a primary pin, and its identifier and the data signal received thereby may be output to the parsing circuit. The pin that receives the data signal later may be designated as the backup pin, and the data signal received thereby may be discarded. Alternatively, if data signals are received simultaneously by both signal input pins, the first signal input pin may be designated as the primary pin, and its identifier and the data signal received thereby may be output to the parsing circuit. The second signal input pin may be designated as the backup pin, and the data signal received thereby may be discarded.

In embodiments of the present disclosure, different pin identifiers may correspond to different signal input pins, and the data signals received by different signal input pins may be different, specifically depending on the way for the LED driver chip (specifically, the driving circuit in the LED driver chip) to process the data signals. In an alternative embodiment, the LED driver chip (specifically, the driving circuit in the LED driver chip) in each LED bead 100 is configured to parse the received data signal to obtain data segment required for the respective LED bead 100. This data segment is then used to drive the LED emitting unit in the LED bead 100 to emit light. Subsequently, the data signal with the remaining data segments may be transmitted to the subsequent LED bead 100. In the present embodiment, with reference to the first breakpoint continuation circuit and/or the second breakpoint continuation circuit provided in the aforementioned embodiments, it is understood that the remaining data segments contained in the data signals from different signal input pins may differ. This leads to variations in how the LED driver chip in the subsequent LED bead 100 processes the signals. Therefore, in the embodiments of the present disclosure, different parsing methods may be implemented for different signal input pins. Specifically, the parsing circuit may employ an appropriate parsing method to extract the data segment required for the corresponding LED bead 100 from the received data signal.

Specifically, the parsing circuit may be configured to receive the pin identifier and data signal output by the monitoring circuit, obtain data segment corresponding to the LED emitting unit from the data signal according to a parsing way corresponding to the pin identifier and output the data segment to the driving circuit. The data segments may contain specific information on how to control the LED emitting unit, such as display attributes like brightness adjustment or color changes. The driving circuit may perform control on the LED emitting unit according to the data segment, so that the LED bead 100 may emit light as intended.

Different signal pins may correspond to different parsing methods. With reference to the way of processing data signals in aforementioned embodiments, if the pin identifier output by the monitoring circuit corresponds to the first signal input pin, the corresponding parsing method may involve obtaining the data segment required for the LED bead 100 from the respective position in the received data signal by parsing according to a sequence of the series connection of the LED beads 100. If the pin identifier output by the monitoring circuit corresponds to the second signal input pin, the corresponding parsing method may not only involve extracting the data segment required for the LED bead 100 from the received data signal at respective position according to a sequence of series connection for LED beads 100 but also delete other data segments preceding this data segment (these data segments correspond to faulty LED beads 100 and are considered as invalid data segments), so as to reduce the amount of data transmitted to subsequent stages and save transmission and processing resources. It should be noted that the processing methods and corresponding parsing methods for the data signals by the LED driver chip described herein are merely exemplary and are not limited to the description herein. There is no limitation on the processing methods and corresponding parsing methods for the data signals in the embodiments of the present disclosure.

In this embodiment, the LED driver chip may include three components: a monitoring circuit, a parsing circuit, and a driving circuit. The monitoring circuit ensures that data signals are correctly identified and transmitted, no matter which pin receives the data signals. The parsing circuit may process the data according to the specific parsing method for respective pin, to ensure the correct extraction of data segments. The driving circuit precisely controls the LED emitting unit based on the extracted data segments, to achieve the display effect as intended. The whole procedure from signal monitoring to parsing and final control without gaps therebetween allows the LED driver chip to flexibly control the LED emitting unit based on different input signals, to ensure the accuracy and efficiency of signal processing while improving the control flexibility and expressiveness of the LED light string.

In implementation, the controller may control the power supply to the LED beads 100 in a plurality of LED light strings. During power supply control, power may be supplied with voltage stabilized to a plurality of LED beads 100 in the same LED light string in parallel, to reduce mutual interference between the LED beads 100. However, although such parallel power supply method ensures consistent brightness across all LED beads and allows other beads to operate normally even if one fails to work, it also has certain drawbacks. For example, when being supplied with power in parallel, current-limiting resistors must be provided for each LED bead 100 to ensure safety of the LED bead 100. These resistors may generate heat and consume power, especially as the number of LED beads 100 increases, the power consumption may be increased.

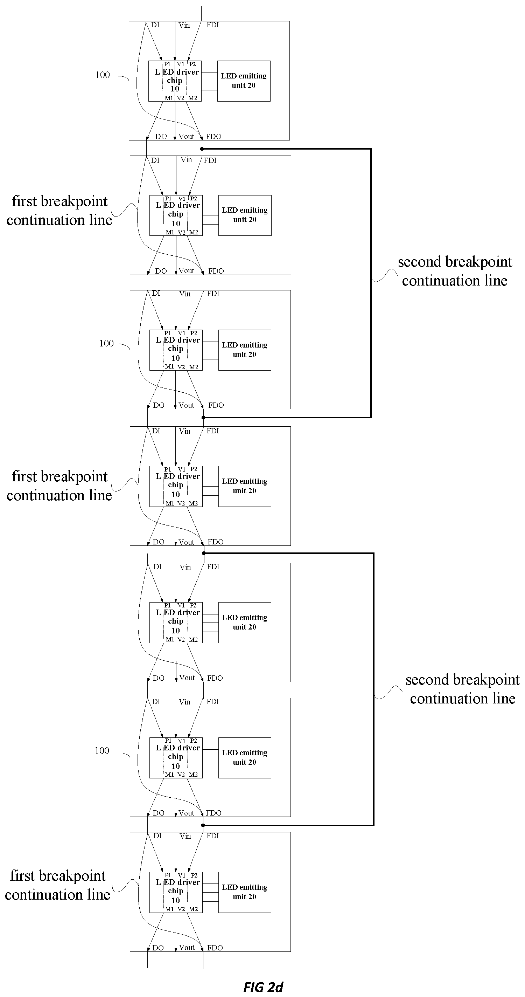

To address these issues, the embodiments of the present disclosure may further provide an LED light string using a serial power supply method. As shown in FIG. 2d, the LED light string may use a serial power supply method. That is to say, the LED beads 100 in the LED light string may be located on the same serial power supply line, and be supplied with power by using a single power source. Each LED bead 100 may receive the same current, to ensure consistent brightness of each LED and avoid brightness unevenness caused by current differences. Additionally, when the serial power supply method is adopted, it may be unnecessary to provide individual current-limiting resistors for each LED bead 100, so that power consumption by these current-limiting resistors may be reduced. Such power-saving effect becomes more significant as the number of LED beads 100 increases. Furthermore, compared to the parallel power supply method, the serial power supply method requires only one constant current source to supply power to the entire LED light string, to simplify the complexity of the driver chip. Moreover, compared to the parallel power supply method, each LED bead 100 supplied with power in a serial power supply method may have lower current, and heat generation by individual LED may be reduced, so that power consumption may be reduced and the lifespan of the LEDs may be extended.

With the serial power supply method, each LED bead 100 in the LED light string may be provided with a power input port (Vin) and a power output port (Vout). The power input port (Vin) and the power output port (Vout) of each LED bead 100 are electrically connected to the power input pin (V 1) and the power output pin (V2) of the internal LED driver chip, respectively, to provide power signals to the LED emitting unit through the LED driver chip. In adjacent LED beads 100, the power output port (Vout) of the preceding LED bead 100 is electrically connected to the power input port (Vin) of the subsequent LED bead 100, so as to form a serial power supply line. The power input port (Vin) of the first LED bead 100 in the LED light string is electrically connected to the power supply terminal, and the power output port (Vout) of the last LED bead 100 in the LED light string is electrically connected to a ground terminal.

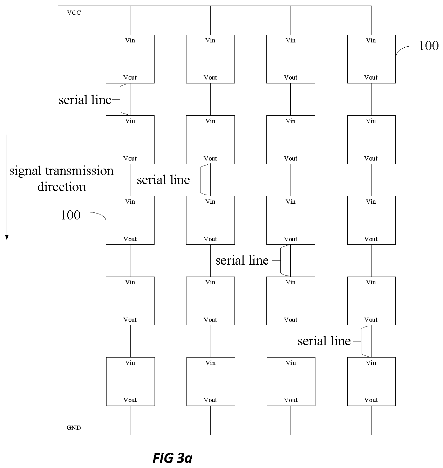

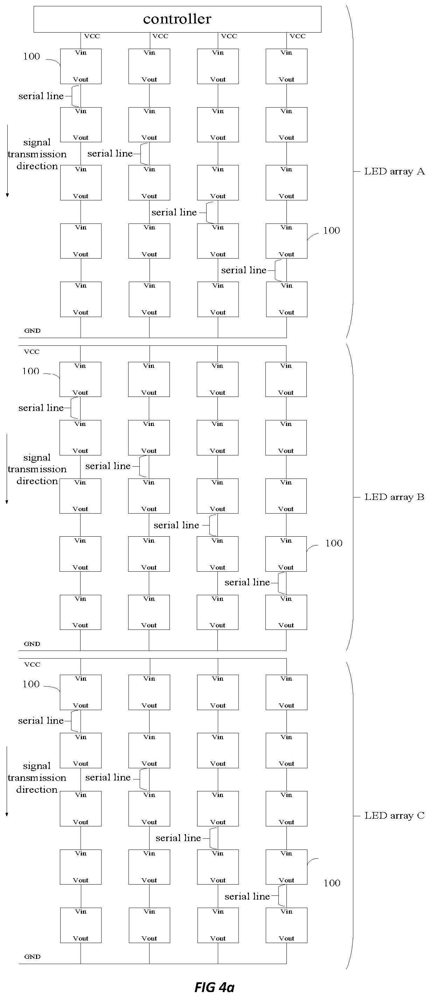

Furthermore, embodiments of the present disclosure further provide an LED light board including the aforementioned LED beads 100 or LED light strings. FIG. 3a illustrates a schematic structural view of an LED light board in serial power supply, provided in exemplary embodiments of the present disclosure. As shown in FIG. 3a, the LED light board may include a plurality of LED light strings. There is no limitation on the number of the light strings included in the LED light board and the number of the light strings may be, for example, 2, 5, 6, 10, 20, 30, or more or less, depending on the application scenario and the size of the display area. For example, FIGS. 3a-3b and FIGS. 4a-4d illustrate each LED light board including four LED light strings as an example, but the present disclosure is not limited thereby. Each LED light string in the LED light board may have the same structure as the LED light strings shown in FIGS. 2a, 2b, 2c, or 2d, and detailed description may be omitted herein to avoid redundancy. In an alternative embodiment, the data signals for the LED light board may be provided by a controller. The controller may include a plurality of communication ports, each of which may be connected to the first signal input port and the second signal input port of the first LED bead 100 in a plurality of LED light string to provide data signals to the LED light strings. In the embodiments of the present disclosure, there is no limitation on specific structure to implement the controller, and any structure may be applicable to the controller in the embodiments of the present disclosure, as long as the controller may be capable of providing data signals to the LED light board. There is no limitation on the position of the controller and the controller may be located at top or bottom of the display where the LED light board is mou9nted, or controller may be mounted at both top and bottom of the LED display where the LED light board is located.

Furthermore, alternatively, as shown in FIG. 3a, the LED light board may further include a power supply terminal and a ground terminal. The power supply terminal may be understood as a power source, and the ground terminal may be understood as a ground signal, for supplying power to the LED light strings in the LED light board. Correspondingly, each LED bead 100 in the LED light board may be further provided with a power input port (Vin) and a power output port (Vout). The power input port (Vin) of each first LED bead 100 in a plurality of LED light strings may be connected in parallel to the power supply terminal, and the power output port (Vout) of each last LED bead 100 in a plurality of LED light strings may be connected in parallel to the ground terminal. The LED beads 100 in the same LED light string may be located on the same serial power supply line and are supplied with power by the power supply terminal of the controller.

Furthermore, the power input port (Vin) and the power output port (Vout) of each LED bead 100 may be electrically connected to the power input pin (V1) and the power output pin (V2) of the internal LED driver chip, respectively, to provide power signals to the LED emitting unit through the LED driver chip. In adjacent LED beads 100 in the same LED light string, the power output port (Vout) of the preceding LED bead 100 may be electrically connected to the power input port (Vin) of the subsequent LED bead 100, so as to form a serial power supply line.

In the present embodiment, the LED beads 100 may not only receive data signals but also receive power signals. The power signals may be provided by the controller, which can be electrically connected to the power supply terminal (VCC) and the ground terminal (GND) shown in FIG. 3a to supply power signals to the LED light strings in the LED light board. Furthermore, alternatively, the controller may be electrically connected to the power supply terminal and the ground terminal directly or electrically connected through connectors or other intermediate circuits, and there is no limitation thereon herein. Each LED bead 100 may be provided with a power input port (Vin) and a power output port (Vout), which are electrically connected to the power input pin (V1) and the power output pin (V2) of the LED driver chip inside the LED bead 100. Such connection may ensure that the LED driver chip can receive power signals from the power input port (Vin) and transmit them to the LED emitting unit to drive the LED emitting unit to display.

In the same LED light string, adjacent LED beads 100 may be electrically connected via their power input port (Vin) and power output port (Vout). Specifically, the power output port (Vout) of the preceding LED bead 100 may be electrically connected to the power input port (Vin) of the subsequent adjacent LED bead 100, so as to form a serial power supply line. Such serial connection may ensure that power signals can be transmitted sequentially along the LED light string.

Additionally, the power input ports (Vin) of each first LED bead 100 in a plurality of LED light strings in the LED light board may be connected in parallel to the power supply terminal. That is to say, all LED light strings may receive power directly from the power supply terminal. Similarly, the power output ports (Vout) of each last LED bead 100 in a plurality of LED light strings may be connected in parallel to the ground terminal, to ensure that the ends of all LED light strings can be grounded properly. When each LED light string is connected in parallel to the power supply terminal and ground terminal, each LED light string may obtain a stable power supply, while the serial power supply line may ensure the continuity of power signals throughout the LED light string.

Furthermore, alternatively, in embodiments of the present disclosure, there is no limitation on the arrangement of the LED light board and the LED light board may be in a row-column arrangement. For example, when being arranged in the row-column arrangement, LED light strings may be arranged into a plurality of rows and columns, and each LED light string may form a row, and LED beads 100 at same position in different LED light strings may form a column. The first LED bead 100 in each row may receive data signals and power signals, which are then transmitted to subsequent LED light strings via serial connections.

For example, as illustrated in FIG. 3a, when being arranged in the row-column arrangement, LED light strings may be arranged into a plurality of columns and rows, and each LED light string may form a column, and LED beads 100 at corresponding positions in each LED light string may form a row. The first LED bead 100 in each column may receive data and power signals, which are then transmitted to subsequent LED light strings via serial connections.

It should be noted that no matter he LED light string is arranged in either of arrangements as described above, the serial power supply lines may ensure that each LED bead 100 can receive data signals and power signals as needed. The specific arrangement may be determined based on implementation requirements and design preferences.

Furthermore, alternatively, in embodiments of the present disclosure, the serial power supply lines between adjacent LED light strings on the LED light board may be connected in parallel to form parallel power supply lines.

The LED beads 100 in a plurality of LED light strings on the LED light board may be arranged in a row-column arrangement. The LED beads 100 in the same LED light string may be located in the same column, while the LED beads 100 at a same position in different LED light strings may be located in the same row. The serial power supply lines between two adjacent rows of LED beads 100 may be connected in parallel to form parallel power supply lines. Alternatively, the LED beads 100 in a plurality of LED light strings may be arranged in a row-column arrangement. The LED beads 100 in the same LED light string may be located in the same row, and the LED beads 100 at a same position in different LED light strings may be located in the same column. The serial power supply lines between two adjacent columns of LED beads 100 are connected in parallel to form parallel power supply lines.

In embodiments of the present disclosure, there is no limitation on the way of connecting the serial power supply lines in parallel. For example, the serial power supply lines may be connected together via wires to form parallel power supply lines.

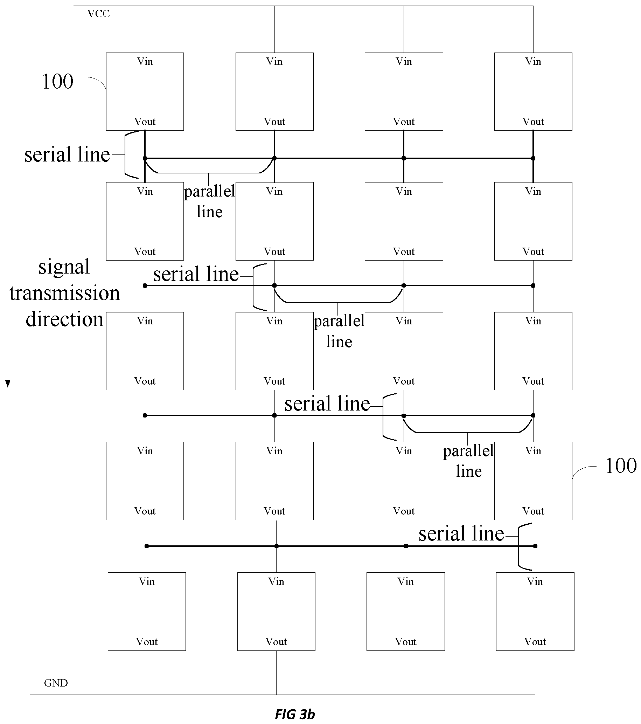

FIG. 3b illustrates a schematic structural view of an LED light board in serial-parallel power supply in exemplary embodiments of the present disclosure. As shown in FIG. 3b, each LED light string on the LED light board may have the same internal structure as the LED light strings in FIG. 3a, and the VCCs and GNDs in FIG. 3b and FIG. 3a have the same meaning. As illustrated in FIG. 3b, each LED light string on the LED light board may contain a plurality of LED beads 100 located in the same column, and LED beads 100 at the same position in different LED light strings (i.e., different columns) may be located in the same row. Each row may include LED beads from different LED light strings, and the serial power supply lines between two adjacent rows of LED beads 100 may be connected in parallel to form parallel power supply lines. Alternatively, the serial power supply lines between two adjacent rows of LED beads 100 may be directly connected via wires, or the serial power supply lines between two adjacent rows of LED beads 100 may be connected in other ways, and there is no limitation on the way of connection. Such connection way may ensure that the LED beads 100 in each row may receive stable power supply while allowing power signals to be transmitted in parallel between different columns. For example, the LED bead 100 in a certain column of the previous row may supply power in parallel to the LED beads 100 in all columns of the next row, while the LED beads 100 in the previous row of the same column may supply power in serial to the LED beads 100 in the next row, so as to achieve a hybrid serial-parallel power supply way. Supplying power in parallel may address the issue that subsequent LED beads 100 may fail to receive power signals due to the failure of a certain LED bead 100 in the serial power supply line. Alternatively, each LED light string on the LED light board may contain a plurality of LED beads 100 located in the same row, with each row representing an LED light string. LED beads 100 at the same position in different LED light strings (i.e., different rows) may be located in the same column, and LED beads 100 from different LED light strings may be included in each column. The serial power supply lines between two adjacent columns of LED beads 100 may be connected in parallel to form parallel power supply lines. Such connection manner may ensure that the LED beads 100 in each column may be supplied with power stably while allowing power signals to be transmitted in parallel between different rows, to achieve a hybrid serial-parallel power supply way. Supplying power in parallel may address the issue that subsequent LED beads 100 fail to receive power signals due to the failure of a certain LED bead 100 in the serial power supply line.

Furthermore, when power is supplied in the hybrid serial-parallel power supply way, since each LED bead 100 simultaneously receives power signals from both the serial power supply lines and the parallel power supply lines, in the embodiments of the present disclosure, each LED bead 100 in the LED light board may further include: a power switching circuit provided between the power input port Vin and the power input pin V1. The power switching circuit may determine the power signal to be used finally between the power signals from the serial power supply lines and the parallel power supply lines.

Specifically, the power switching circuit may detect whether power signals are received in the serial power supply lines and the parallel power supply lines. If power signals are detected in both the serial power supply lines and the parallel power supply lines simultaneously, the power switching circuit may connect the serial power supply line to the power input pin V1, to supply power in the serial power supply way preferentially. That is to say, the serial power supply line may be used preferentially as the primary power supply path, so as to fully leverage the advantages of the serial power supply way. Alternatively, if a power signal is detected on only one of the serial power supply lines and the parallel power supply lines and there no power signal detected on the other, the power switching circuit may connect the line with the power signal detected to the power input pin V1, to address the power issue for the LED bead 100 preferentially.

Furthermore, if there is no power signal in the serial power supply line due to the failure of a preceding LED bead 100, the parallel power supply line may be switched to be used as a backup line to promptly supply power to subsequent LED beads 100, so as to ensure normal operations of subsequent LED beads 100. In this way, it may be ensured that the power supply for LED beads 100 may have high reliability and flexibility. With serial power supply line as the primary power supply path, power consumption may be reduced, consistency in the brightness of LED beads 100 may be ensured, and the circuit complexity of the driver chip may be simplified. With the parallel power supply line as a backup power supply path, it may be ensured that subsequent LED beads 100 may still receive power signals and work normally even if there is failure in the primary path.

In the embodiments of the present disclosure, the power switching circuit included in each LED bead 100 on the LED light board may be implemented by using relays or electronic switches, but is not limited thereto.

Furthermore, the embodiments of the present disclosure may provide an LED display including the LED light board as shown in FIG. 3a or FIG. 3b. The LED display provided according to embodiments of the present disclosure may include a controller and at least two LED light boards. The at least two LED light boards may be sequentially connected together to form the LED display, and the controller may be provided at top and/or bottom of the LED display. That is to say, the controller may be provided at top of the LED display, at bottom of the LED display, or at both top and bottom of the LED display. The controller may be configured to drive LED light strings of a certain length, and there is no limitation on the length. For example, the controller may be configured to drive LED light strings with a length of 5 meters, 6 meters, or 8 meters. These numbers are merely examples, and the length of LED light strings driven by each controller may be longer or shorter. If a single controller is used, the controller may be provided at top or bottom of the LED display. When more LED light boards need to be driven, two controllers may be used, and may be provided at top and bottom of the display, respectively. With such configuration there may be no obstructions caused by controllers in the middle of the LED display, so as to meet the requirement on transparency of the display and thus the LED display may be implemented as a transparent display. When the controller is provided at top of the display or when there are two controllers (one at top and the other at bottom), the entire display may be configured as a suspended display, which is suitable for venues with high ceilings, such as exhibition halls, theaters, or large conference rooms, and allows flexible mounting. If the controller is provided only at bottom of the display, the display typically has a base to support the display, which could be in a freestanding configuration, and may be suitable for scenarios where hanging mounting is not required, such as store windows or small display spaces. Optionally, the controller and LED light board may be electrically connected directly or connected via dedicated connectors, which may not only ensure the reliability of the electrical connection but also facilitate mounting and maintenance.

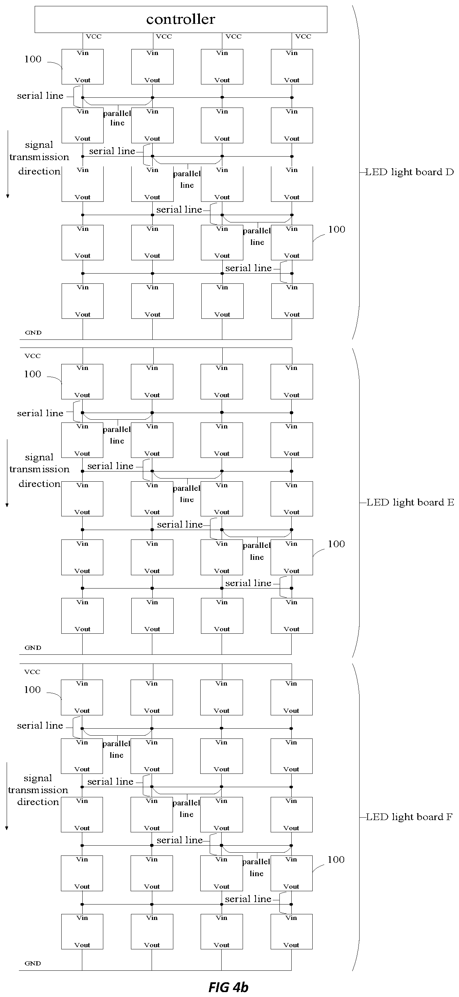

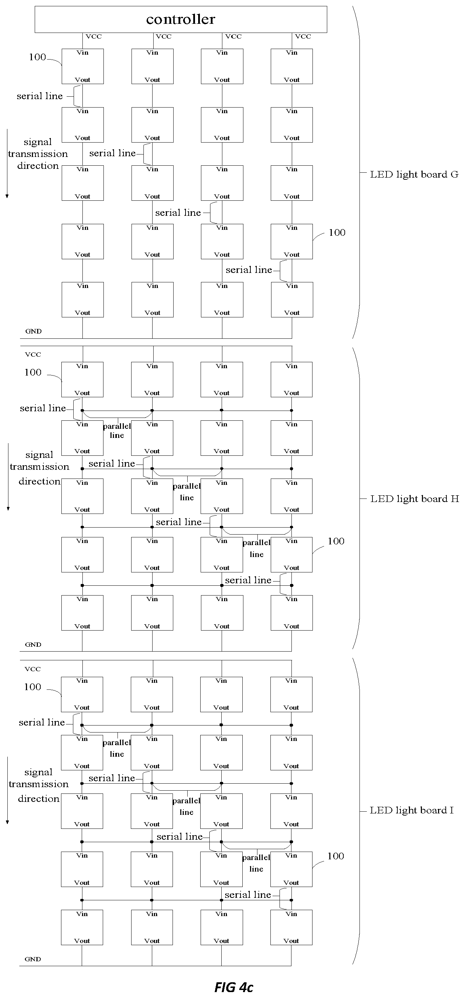

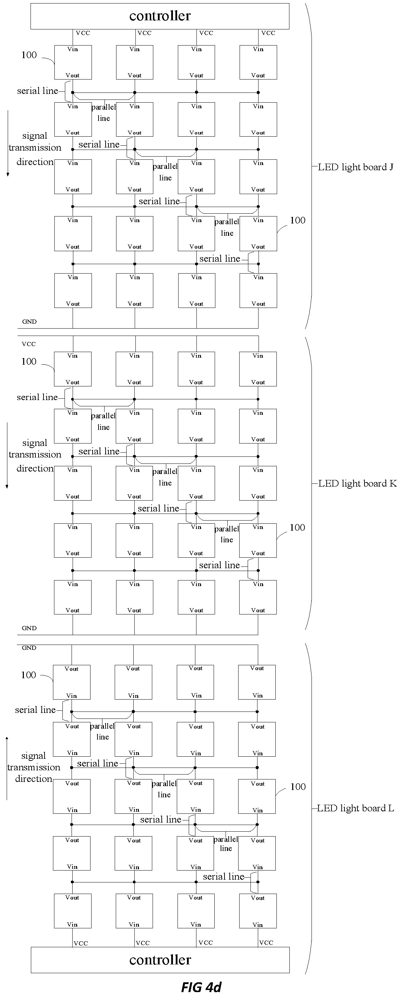

There is no limitation on the number of LED light boards included in the LED display in the embodiments of the present disclosure, and the number may be 2, 3, 4, 5, 10, 30, or any other number, depending on the application scenario and the size of space available for the display. For example, FIG. 4a illustrates three LED light boards A, B, and C; FIG. 4b illustrates three LED light boards D, E, and F; FIG. 4c illustrates three LED light boards G, H, and I; and FIG. 4d illustrates three LED light boards J, K, and L. Additionally, the LED light boards included in the LED display may be identical LED light boards or different LED light boards. Identical LED light boards refer to the LED light boards with the same structure, type, size, and power supply way, while different LED light boards differ in at least one of structure, type, size, and power supply way. Such flexibility allows the LED display to use either identical or different LED light boards to meet varying display requirements or application scenarios. Optionally, the LED display shown in FIGS. 4a-4d may use identical LED light boards. The differences between the LED display shown in FIGS. 4a-4d lie in the number and position of controllers, the signal transmission direction of part of the LED light boards, and the power supply way, as described in subsequent embodiments.

In the LED display, the signal transmission directions of at least two LED light boards may be the same, or at least some adjacent LED light boards of the at least two LED light boards may have opposite signal transmission directions. For example, the signal transmission direction of the last LED light board in at least two LED light boards, may be opposite to that of other LED light boards. The signal transmission direction herein may include the transmission directions of data signals and power signals. With respect to one LED light board, the signal transmission direction may be from top to bottom, from bottom to top, from left to right, or from right to left.

In embodiments of the present disclosure, there is no limitation on the way of supplying power to each LED light board in the LED display. Alternatively, each LED light board in the LED display may be supplied with power in a way that the power supply to all LED light board may be in serial. Furthermore, alternatively, each LED light board in the LED display may be supplied with power in a way that the serial power supply lines between adjacent LED light strings in the LED light board may be connected in parallel, so as to form parallel power supply lines to supply power to the LED display all in a hybrid serial-parallel power supply way. Alternatively, each LED light board in the LED display may be supplied with power in a way that some LED light boards may be supplied with power in serial and some LED light boards may be supplied with power in parallel.

FIG. 4a illustrates a schematic structural view of an LED display provided in exemplary embodiments of the present disclosure. As shown in FIG. 4a, the LED display consists of three LED light boards A-C. In FIG. 4a, the internal structure of each LED light string in each LED light board is identical to that of the LED light strings in FIG. 3a, and VCCs and GNDs in FIG. 4a and FIG. 3a have the same meaning, and thus detailed description would be omitted herein to avoid redundancy.

These LED light boards may be supplied with power in serial, and the three LED light boards may be connected together to form a complete LED display. In the LED display shown in FIG. 4a, the controller may be provided at top of the LED display, and the signal transmission directions of the three LED light boards A-C are the same, i.e., from top to bottom, so as to ensure a unified signal transmission direction for the entire LED display.

FIG. 4b illustrates a schematic structural view of another LED display provided in exemplary embodiments of the present disclosure. As shown in FIG. 4b, the LED display consists of three LED light boards D-F. In FIG. 4b, the internal structure of each LED light string in each LED light board is identical to that of the LED light strings in FIG. 3a, and VCCs and GNDs in FIG. 4b and FIG. 3a have the same meaning, and thus detailed description would be omitted herein to avoid redundancy.

In addition to the serial power supply in which these LED light boards may be supplied with power in serial, each serial power supply line may be connected together to form parallel power supply lines, and the LED display may be supplied with power in a hybrid serial-parallel power supply way. The three LED light boards D-F may be connected together to form a complete LED display. In the LED display shown in FIG. 4b, the controller may be provided at top of the LED display, and the signal transmission directions of the three LED light boards D-F are the same, i.e., from top to bottom, so as to ensure a unified signal transmission direction for the entire LED display.

FIG. 4c illustrates a schematic structural view of yet another LED display provided in exemplary embodiments of the present disclosure. As shown in FIG. 4c, the LED display consists of three LED light boards G-I. In FIG. 4c, the internal structure of each LED light string in each LED light board is identical to that of the LED light strings in FIG. 3a, and VCCs and GNDs in FIG. 4c and FIG. 3a have the same meaning, and thus detailed description would be omitted herein to avoid redundancy.

In FIG. 4c, the LED light boards G and I may be supplied with power in serial, the LED light boards H may be supplied with power in a hybrid serial-parallel power supply way. The three LED light boards G-I may be connected together to form a complete LED display. In the LED display shown in FIG. 4c, the controller may be provided at top of the LED display, and the signal transmission directions of the three LED light boards G-I are the same, i.e., from top to bottom, so as to ensure a unified signal transmission direction for the entire LED display.

FIG. 4d illustrates a schematic structural view of yet another LED display provided in exemplary embodiments of the present disclosure. As shown in FIG. 4d, the LED display consists of three LED light boards J-L. In FIG. 4d, the internal structure of each LED light string in each LED light board is identical to that of the LED light strings in FIG. 3a, and VCCs and GNDs in FIG. 4d and FIG. 3a have the same meaning, and thus detailed description would be omitted herein to avoid redundancy.

These LED light boards may be supplied with power in parallel, and the three LED light boards J-L may be connected together to form a complete LED display. In the LED display shown in FIG. 4d, there are two controllers, which may be provided at top and bottom of the LED display, respectively, and the signal transmission directions of the LED light boards J and K are the same, i.e., from top to bottom, and the signal transmission direction of the LED light board L is opposite, i.e., from bottom to top, so as to prevent the LED display from being blocked due to the controller.

In the above embodiments, LED light boards are characterized by breakpoint continuation and may be supplied with power in serial or a hybrid serial-parallel power supply way. Additionally, with the consideration that when the LED light board is supplied with power in parallel, it is required to provide current limiting resistors for each LED bead to limit current for the safety of LED beads. These resistors may generate heat and consume power, especially as the number of LED beads increases, the power consumption increases. To address this issue, embodiments of the present disclosure may further provide another LED light board, characterized by being supplied with power in a hybrid serial-parallel power supply way, with no limitation on whether it supports breakpoint continuation.

Specifically, another LED light board provided in embodiments of the present disclosure may include a plurality of LED light strings. Each LED light string may include a plurality of LED beads, each of which may be provided with a power input port and a power output port. Each LED bead may be provided with an LED driver chip and an LED emitting unit encapsulated therein. The power input port and power output port of each LED bead may be electrically connected to the power input pin and power output pin of an internal LED driver chip, respectively, to provide power signals to the LED emitting unit through the LED driver chip. In the same LED light string, the power output port and the power input port of adjacent LED beads may be electrically connected to form a serial power supply line. The serial power supply lines between adjacent LED light strings may be connected in parallel to form parallel power supply lines.

In an alternative embodiment, the LED beads in the plurality of LED light strings may be arranged in a row-column arrangement. The LED beads in the same LED light string may be located in the same column, while the LED beads at same position in different LED light strings may be located in the same row. The serial power supply lines between adjacent rows of LED beads may be connected in parallel to form parallel power supply lines. Alternatively, the LED beads in the plurality of LED light strings may be arranged in a row-column arrangement. The LED beads in the same LED light string are located in the same row, and the LED beads at same position in different LED light strings may be located in the same column. The serial power supply lines between adjacent columns of LED beads may be connected in parallel to form parallel power supply lines.

Furthermore, alternatively, each LED bead may include a power switching circuit provided between the power input port and the power input pin. The power switching circuit may connect the serial power supply line to the power input pin when detecting power signals in both the serial power supply lines and the parallel power supply lines simultaneously. Alternatively, when detecting a power signal in one of the serial power supply lines and the parallel power supply lines but no power signals is detected on the other, the power switching circuit may connect the line where the power signal is detected to the power input pin.

The detailed descriptions on structures of the LED light board, the LED light string, the serial-parallel power supply lines, the power switching circuit, and so on may be seen in the aforementioned embodiments, which will not be repeated here to avoid redundancy. Furthermore, in the LED light board provided in the present embodiment, a structure feature of breakpoint continuation may be introduced, so that an LED light board as shown in FIG. 3b may be obtained. The detailed description on this LED light board may also be found in the aforementioned embodiments, which will not be repeated here to avoid redundancy.

In embodiments of the present disclosure, the LED light board may be supplied with power in a hybrid serial-parallel power supply way, to reduce power consumption and address the issue of power outages in subsequent LED beads caused by malfunction of some LED bead in a serial power supply way, and the number of LED beads in power outage may be reduced, to reduce a risk that the whole LED display does not work, and improve the reliability of the LED display.

In the above embodiments, LED display is characterized by breakpoint continuation and may be supplied with power in serial or a hybrid serial-parallel power supply way. Additionally, with the consideration that when the LED display is supplied with power in parallel, it is required to provide current limiting resistors for each LED bead to limit current for the safety of LED beads. These resistors may generate heat and consume power, especially as the number of LED beads increases, the power consumption increases. To address this issue, embodiments of the present disclosure may further provide another LED display, characterized by being supplied with power in a hybrid serial-parallel power supply way, with no limitation on whether it supports breakpoint continuation.

Specifically, another LED display provided in embodiments of the present disclosure may include a controller and at least two LED light boards. Each LED light board may include a plurality of LED light strings, and each LED light string may include a plurality of LED beads. Each LED bead may be provided with a power input port and a power output port, and may be provided with an LED driver chip and an LED emitting unit encapsulated therein. The controller may be electrically connected to the power input port of the first LED bead and the power output port of the last LED bead in each LED light string to provide power signals to the LED beads. The power input port and the power output port of each LED bead may be electrically connected to the power input pin and the power output pin of the internal LED driver chip, respectively, to supply power signals to the LED emitting unit via the LED driver chip. In each LED light board, the power input port and the power output port of adjacent LED beads in each LED light string may be electrically connected to form a serial power supply line, and the serial power supply lines between adjacent LED light strings may be connected in parallel to form a parallel power supply line.

In an alternative embodiment, in the LED light board, the LED beads in the plurality of LED light strings may be arranged in a row-column arrangement. The LED beads in the same LED light string may be located in the same column, while the LED beads at same position in different LED light strings may be located in the same row. The serial power supply lines between adjacent rows of LED beads may be connected in parallel to form parallel power supply lines. Alternatively, in the LED light board, the LED beads in the plurality of LED light strings may be arranged in a row-column arrangement. The LED beads in the same LED light string are located in the same row, and the LED beads at same position in different LED light strings may be located in the same column. The serial power supply lines between adjacent columns of LED beads may be connected in parallel to form parallel power supply lines.

In an alternative embodiment, in the LED light board, each LED bead may include a power switching circuit provided between the power input port and the power input pin. The power switching circuit may connect the serial power supply line to the power input pin when detecting power signals in both the serial power supply lines and the parallel power supply lines simultaneously. Alternatively, when detecting a power signal in one of the serial power supply lines and the parallel power supply lines but no power signals is detected on the other, the power switching circuit may connect the line where the power signal is detected to the power input pin.

The detailed descriptions on structures of the LED display, the LED light board, the serial-parallel power supply lines, the power switching circuit, the LED beads and so on may be seen in the aforementioned embodiments, which will not be repeated here to avoid redundancy. Furthermore, in the LED light board included in the LED display, a structure feature of breakpoint continuation may be introduced, so that an LED display as shown in FIG. 4b or FIG. 4d may be obtained. The detailed description on this LED display shown in FIG. 4b or FIG. 4d may also be found in the aforementioned embodiments, which will not be repeated here to avoid redundancy.

The LED display provided according to embodiments of the present disclosure may be supplied with power in a hybrid serial-parallel power supply way, to reduce power consumption and address the issue of power outages in subsequent LED beads caused by malfunction of some LED bead in a serial power supply way, and the number of LED beads in power outage may be reduced, to reduce a risk that the whole LED display does not work, and improve the reliability of the LED display.

It should be noted that the terms "first", "second", etc., in this specification may be used to distinguish between different messages, devices, modules, etc., and do not imply any order or limitation that "first" and "second" must be of different types.

It should be noted that the terms "include", "comprise", or any variations thereof are intended to encompass non-exclusive inclusion, such that a process, method, product, or device that includes a list of elements not only includes those elements but may also include other elements not explicitly listed or inherent to such process, method, product, or device. Without further limitation, an element defined by the phrase "includes a ..." does not exclude the presence of additional identical elements in the process, method, product, or device.

The above is merely embodiments of the present disclosure and is not intended to limit the present disclosure. For those skilled in the art, the present disclosure may have various modifications and changes. Any modifications, equivalent replacements, improvements, etc., made within the spirit and principles of the present disclosure are intended to be included within the scope of the claims of the present disclosure.

## Claims

1. An LED light string, comprising:
a plurality of LED beads connected in series; each LED bead is provided with a first signal input port, a first signal output port, a second signal input port, and a second signal output port, and the LED bead is provided with an LED driver chip and an LED emitting unit encapsulated therein,
wherein the first signal input port, the second signal input port, the first signal output port, and the second signal output port of each LED bead are electrically connected to a first signal input pin, a second signal input pin, a first signal output pin, and a second signal output pin of the LED driver chip encapsulated in the LED bead, respectively, so as to transmit data signals to the LED emitting unit via any signal input pin of the LED driver chip;
the first signal output port and the second signal output port of adjacent LED beads are electrically connected to the first signal input port and the second signal input port, respectively, to form a serial signal line; and
the first signal input port and the second signal output port of each LED bead are electrically connected directly by bypassing the LED driver chip inside the LED bead to form a first breakpoint continuation line.

2. The LED light string according claim 1, wherein the second signal output port of a first LED bead and the second signal input port of a second LED bead are electrically connected to form a second breakpoint continuation line;
wherein, the first LED bead is any LED bead of the LED light string, and there are at least two LED beads between the second LED bead and the first LED bead.

3. The LED light string according claim 2, wherein the first LED bead and the second LED bead are grouped into one bead group, and a plurality of beads are provided in the LED light string, different bead groups have different first LED bead and second LED bead.

4. The LED light string according claim 2, wherein the LED driver chip comprises: a monitoring circuit, electrically connected to the first signal input pin and the second signal input pin; a parsing circuit, electrically connected to the monitoring circuit; and a driving circuit, electrically connected to the parsing circuit;
wherein the monitoring circuit is configured to output a data signal and a pin identifier of any signal input pin to the parsing circuit, when the data signal is received by the any signal input pin; the parsing circuit is configured to obtain data segment corresponding to the LED emitting unit from the data signal according to a parsing way corresponding to the pin identifier and output the data segment to the driving circuit; the driving circuit performs control on the LED emitting unit according to the data segment; wherein different signal pin corresponds to different parsing way.

5. The LED light string according any of claims 1-4, wherein each LED bead is provided with a power input port and a power output port;
the power input port and the power output port of each LED bead are electrically connected to the power input pin and the power output pin of the LED driver chip inside the LED bead, respectively, to provide power signals to the LED emitting unit via the LED driver chip;
the power output port and the power input port of adjacent LED beads are electrically connected, so as to form a serial power supply line;
the power input port of a first LED bead in the LED light string is electrically connected to a power supply terminal, and the power output port of a last LED bead in the LED light string is electrically connected to a ground terminal.

6. An LED light board, comprising: a plurality of LED light strings; each LED light string comprises a plurality of LED beads, and each LED bead is provided with a first signal input port, a first signal output port, a second signal input port, and a second signal output port, and the LED bead is provided with an LED driver chip and an LED emitting unit encapsulated therein,
wherein the first signal input port, the second signal input port, the first signal output port, and the second signal output port of each LED bead are electrically connected to a first signal input pin, a second signal input pin, a first signal output pin, and a second signal output pin of the LED driver chip inside the LED bead, respectively, so as to transmit data signals to the LED emitting unit via any signal input pin of the LED driver chip;
the first signal output port and the second signal output port of adjacent LED beads are electrically connected to the first signal input port and the second signal input port, respectively, to form a serial signal line; and
the first signal input port and the second signal output port of each LED bead are electrically connected directly by bypassing the LED driver chip inside the LED bead to form a first breakpoint continuation line.

7. The LED light board according claim 6, wherein the second signal output port of a first LED bead and the second signal input port of a second LED bead are electrically connected to form a second breakpoint continuation line;
wherein the first LED bead is any LED bead in the LED light string, and there are at least two LED beads between the second LED bead and the first LED bead.

8. The LED light board according claim 7, wherein the first LED bead and the second LED bead are grouped into one bead group, and a plurality of beads are provided in the LED light string, different bead groups have different first LED bead and second LED bead.

9. The LED light board according claim 7, wherein the LED driver chip comprises: a monitoring circuit, electrically connected to the first signal input pin and the second signal input pin; a parsing circuit, electrically connected to the monitoring circuit; and a driving circuit, electrically connected to the parsing circuit;
wherein the monitoring circuit is configured to output a data signal and a pin identifier of any signal input pin to the parsing circuit, when the data signal is received by the any signal input pin; the parsing circuit is configured to obtain data segment corresponding to the LED emitting unit from the data signal according to a parsing way corresponding to the pin identifier and output the data segment to the driving circuit; the driving circuit performs control on the LED emitting unit according to the data segment; wherein different signal pin corresponds to different parsing way.

10. The LED light string according any of claims 6-9, wherein each LED bead is further provided with a power input port and a power output port;
the power input port and the power output port of each LED bead are electrically connected to the power input pin and the power output pin of the LED driver chip inside the LED bead, respectively, to provide power signals to the LED emitting unit via the LED driver chip;
the power output port and the power input port of adjacent LED beads are electrically connected, so as to form a serial power supply line;
the power input port of a first LED bead in the LED light string is electrically connected to a power supply terminal, and the power output port of a last LED bead in the LED light string is electrically connected to a ground terminal.

11. The LED light board according claim 10, wherein the serial power supply lines of two adjacent LED light strings are connected in parallel, to form a parallel power supply line.

12. The LED light board according claim 11, wherein the LED beads in the plurality of LED light strings are arranged in a row-column arrangement, the LED beads in a same LED light string are located in a same column, while the LED beads at a same position in different LED light strings are located in a same row, and the serial power supply lines between two adjacent rows of LED beads are connected in parallel to form parallel power supply lines;
or,
the LED beads in the plurality of LED light strings are arranged in a row-column arrangement, the LED beads in a same LED light string are located in a same row, and the LED beads at a same position in different LED light strings are located in a same column, and the serial power supply lines between two adjacent columns of LED beads are connected in parallel to form parallel power supply lines.

13. The LED light board according claim 11, wherein each LED bead further comprises: a power switching circuit provided between the power input port and the power input pin.;
the power switching circuit connects the serial power supply line to the power input pin, when power signals are detected in both the serial power supply lines and the parallel power supply lines simultaneously; or, when a power signal is detected in one of the serial power supply line and the parallel power supply line but no power signal is detected in the other of the serial power supply line and the parallel power supply line, the power switching circuit connects the one where the power signal is detected to the power input pin.

14. An LED display, comprising: a controller and at least two LED light boards; the at least two LED light boards are sequentially connected together to form the LED display; the controller is provided at top and/or bottom of the LED display;
each LED light board comprises: a plurality of LED light strings; each LED light string comprises a plurality of LED beads, each LED bead is provided with a first signal input port, a first signal output port, a second signal input port, and a second signal output port, and the LED bead is provided with an LED driver chip and an LED emitting unit encapsulated therein,
wherein the first signal input port, the second signal input port, the first signal output port, and the second signal output port of each LED bead are electrically connected to a first signal input pin, a second signal input pin, a first signal output pin, and a second signal output pin of the LED driver chip inside the LED bead, respectively, so as to transmit data signals to the LED emitting unit via any signal input pin of the LED driver chip;
the first signal output port and the second signal output port of adjacent LED beads are electrically connected to the first signal input port and the second signal input port, respectively, to form a serial signal line; and
the first signal input port and the second signal output port of each LED bead are electrically connected directly by bypassing the LED driver chip inside the LED bead to form a first breakpoint continuation line;
signal transmission directions of the at least two LED light boards are the same, or at least some adjacent LED light boards of the at least two LED light boards have opposite signal transmission directions.

15. The LED display according claim 14, wherein the second signal output port of a first LED bead and the second signal input port of a second LED bead are electrically connected to form a second breakpoint continuation line;
wherein the first LED bead is any LED bead in the LED light string, and there are at least two LED beads between the second LED bead and the first LED bead.

16. The LED display according claim 14 or claim 15, wherein each LED bead is provided with a power input port and a power output port;
the power input port and the power output port of each LED bead are electrically connected to the power input pin and the power output pin of the LED driver chip, respectively, to provide power signals to the LED emitting unit via the LED driver chip;
the power output port and the power input port of adjacent LED beads are electrically connected, so as to form a serial power supply line;
the power input port of a first LED bead in the LED light string is electrically connected to a power supply terminal, and the power output port of a last LED bead in the LED light string is electrically connected to a ground terminal.

17. The LED display according claim 16, wherein the serial power supply lines of two adjacent LED light strings are connected in parallel, to form a parallel power supply line.

18. An LED light board, comprising: a plurality of LED light strings, each LED light string comprises: a plurality of LED beads, each LED bead is provided with a power input port and a power output port, the LED bead is provided with an LED driver chip and an LED emitting unit encapsulated therein,
the power input port and the power output port of each LED bead are electrically connected to the power input pin and the power output pin of the LED driver chip, respectively, to provide power signals to the LED emitting unit via the LED driver chip;
the power output ports and the power input port of adjacent LED beads are electrically connected in a same LED light string, so as to form a serial power supply line; and the serial power supply lines of adjacent LED light strings are connected in parallel, to form a parallel power supply line.

19. The LED light board according claim 18, wherein the LED beads in the plurality of LED light strings are arranged in a row-column arrangement, the LED beads in a same LED light string are located in a same column, while the LED beads at a same position in different LED light strings are located in a same row, and the serial power supply lines between two adjacent rows of LED beads are connected in parallel to form parallel power supply lines;
or,
the LED beads in the plurality of LED light strings are arranged in a row-column arrangement, the LED beads in a same LED light string are located in a same row, and the LED beads at a same position in different LED light strings are located in a same column, and the serial power supply lines between two adjacent columns of LED beads are connected in parallel to form parallel power supply lines.

20. The LED light board according claim 19, wherein each LED bead further comprises: a power switching circuit provided between the power input port and the power input pin.;
the power switching circuit connects the serial power supply line to the power input pin when power signals are detected in both the serial power supply lines and the parallel power supply lines simultaneously; or, when a power signal is detected in one of the serial power supply line and the parallel power supply line but no power signal is detected in the other of the serial power supply line and the parallel power supply line, the power switching circuit connects the one where the power signal is detected to the power input pin.

21. An LED display comprising: a controller and at least two LED light boards; each LED light board comprises: a plurality of LED light strings;
each LED light string comprises: a plurality of LED beads, and each LED bead is provided with a power input port and a power output port; the LED bead is provided with an LED driver chip and an LED emitting unit encapsulated therein;
the controller is electrically connected to a power input port of a first LED bead and a power output port of a last LED bead in each LED light string, so as to supply power signal to LED beads;
the power input port and the power output port of each LED bead are electrically connected to a power input pin and a power output pin of the LED driver chip encapsulated in the LED bead, respectively, so as to supply power signals to the LED emitting unit via the LED driver chip;
in each LED light board, the power output port and the power input port of adjacent LED beads in each LED light string are electrically connected, to form a serial power supply line, and the serial power supply lines of adjacent LED light strings are connected in parallel, to form a parallel power supply line.

22. The LED display according claim 21, wherein in the LED light board, the LED beads in the plurality of LED light strings are arranged in a row-column arrangement, the LED beads in a same LED light string are located in a same column, while the LED beads at a same position in different LED light strings are located in a same row, and the serial power supply lines between two adjacent rows of LED beads are connected in parallel to form parallel power supply lines;
or,
in the LED light board, the LED beads in the plurality of LED light strings are arranged in a row-column arrangement, the LED beads in a same LED light string are located in a same row, and the LED beads at a same position in different LED light strings are located in a same column, and the serial power supply lines between two adjacent columns of LED beads are connected in parallel to form parallel power supply lines.

23. The LED display according claim 22, wherein in the LED light board, each LED bead further comprises: a power switching circuit provided between the power input port and the power input pin;
the power switching circuit connects the serial power supply line to the power input pin, when power signals are detected in both the serial power supply lines and the parallel power supply lines simultaneously; or, when a power signal is detected in one of the serial power supply line and the parallel power supply line but no power signal is detected in the other of the serial power supply line and the parallel power supply line, the power switching circuit connects the one where the power signal is detected to the power input pin.
